Europäisches Patentamt

European Patent Office

Office européen des brevets

(19)

(11) **EP 0 641 446 B1**

(12) **EUROPÄISCHE PATENTSCHRIFT**

(45) Veröffentlichungstag und Bekanntmachung des Hinweises auf die Patenterteilung:
**08.01.1997 Patentblatt 1997/02**

(51) Int Cl.6: **G01R 31/00**

(21) Anmeldenummer: 93909773.9

(86) Internationale Anmeldenummer:
**PCT/DE93/00433**

(22) Anmeldetag: **18.05.1993**

(87) Internationale Veröffentlichungsnummer:
**WO 93/24845 (09.12.1993 Gazette 1993/29)**

(54) **PRÜFVERFAHREN ZUR QUALITÄTSKONTROLLE VON ELEKTROMAGNETISCH BETÄTIGTEN SCHALTGERÄTEN**

TESTING PROCESS FOR THE QUALITY CONTROL OF ELECTROMAGNETICALLY ACTUATED SWITCHING DEVICES

PROCEDE DE VERIFICATION PERMETTANT DE CONTROLER LA QUALITE D'APPAREILS DE COMMUTATION COMMANDES ELECTROMAGNETIQUEMENT

(84) Benannte Vertragsstaaten:
**CH DE ES FR GB IT LI PT SE**

(30) Priorität: **22.05.1992 DE 4217065**
**22.05.1992 DE 4217067**
**22.05.1992 DE 4217105**

(43) Veröffentlichungstag der Anmeldung:
**08.03.1995 Patentblatt 1995/10**

(73) Patentinhaber: **SIEMENS AKTIENGESELLSCHAFT**
**80333 München (DE)**

(72) Erfinder:
• **NOE, Ernst-Ludwig**
**D-8551 Heroldsbach (DE)**

• **SCHWARZ, Peter**
**D-8520 Erlangen (DE)**

(56) Entgegenhaltungen:
**US-A- 3 560 844**

• **SOVIET PATENTS ABSTRACTS Section EI, Week J51, 9. Februar 1983 Derwent Publications Ltd., London, GB; Class V, & SU,907 623**
• **SOVIET PATENTS ABSTRACTS Section EI, Week 8712, 1. April 1987 Derwent Publications Ltd., London, GB; Class T, AN 87-085625 & SU-A-1 247 963**
• **SOVIET PATENTS ABSTRACTS Section EI, Week K41, 23. November 1983 Derwent Publications Ltd., London, GB; Class T, AN 83788468 & SU-A-983 655**

**Beschreibung**

Die Erfindung bezieht sich auf ein Prüfverfahren zur Qualitätskontrolle von elektromagnetisch betätigten Schaltgeräten, bei denen durch Betätigen eines Magnetankers Stromkontakte geschlossen werden, wobei die Prüfung mittels einer Analyse der unter Betriebsbedingungen auftretenden Vibrationen bzw. der Schallemission umfaßt, wozu der bei Betätigung des Schaltgerätes abgegebene Schall mittels eines Sensors erfaßt und einer Auswerteeinrichtung zur Diskriminierung des zeitlichen und/oder frequenzmäßigen Verlaufs einzelner Schallanteile zugeführt wird und geht aus von SU-A-907 623.

Es wurde bereits vorgeschlagen, Funktionsprüfungen und die Qualitätskontrolle von Schaltgeräten mittels einer Schwingungsanalyse beim Schalten durchzuführen. Aus der JP-A-01/80876 ist ein Verfahren speziell zur Bestimmung der Kontaktkraft bekannt, bei dem die beim Kontakt- und Ankerschließen erzeugten Vibrationssignale ausgewertet werden. Weiterhin ist aus der SU-A-983 655 ein Verfahren der eingangs genannten Art bekannt, bei dem in zwei unterschiedlichen Testzyklen der Magnetanker mit unterschiedlichen Strömen betrieben wird, die dabei erzeugten Schallsignale mittels eines akustischen Sensors erfaßt und daraus eine Qualitätsaussage für das Schaltgerät abgeleitet wird. Schließlich ist aus der SU-A-1 272 374 eine Anordnung zur Qualitätskontrolle bei gekapselten Reed-Kontakten bekannt, bei dem die Spule für die elektromagnetisch betätigten Kontakte erregt und die beim Betätigen des Relais erzeugten Schwingungen im offenen und im geschlossenen Zustand des Relais erfaßt und ausgewertet werden.

Daneben ist aus der SU-A-907 623 ein Verfahren der eingangs genannten Art bekannt, bei dem Schwingungs- und Schallspektren als Gesamtes untersucht und aus den Oszillations-Prozessen mittels statistischer Methoden spezifischer Kriterien für Voraussagen über zukünftige Versagensraten eines Schaltgerätes abgeleitet werden.

Aufgabe der Erfindung ist es demgegenüber, die bekannten Prüfverfahren im Sinne einer Objektivierung der Qualitätskontrolle weiter zu verbessern. Solche Verfahren sollen bei unterschiedlichen elektromagnetisch betätigten Schaltgeräten anwendbar sein und jeweils für einen Anwendungsfall konkret die Klassifikation von ggfs. vorhandenen Fehlern ermöglichen. Darüber hinaus soll das Verfahren auch für die Bewertung von Geräuschen bei Relais, insbesondere von Kraftfahrzeug-Blinkrelais, eingesetzt werden können.

Die Aufgabe ist in erster Realisierung der Erfindung dadurch gelöst, daß die durch das Aufschlagen der Kontakte einerseits und des Ankers andererseits verursachten Schallsignale separat erfaßt werden und voneinander getrennt werden und daß allein das vom Ankeraufschlag bewirkte Schallsignal ausgewertet wird.

Dies gilt insbesondere für einen Anwendungsfall bei Relais als solche Schaltgeräte, bei denen der elektromagnetisch betätigte Anker auf dem Magnetkern zwecks Schließen der Kontakte aufschlagen muß. Demzufolge kann dort z.B. ein ggfs. auftretendes Kontaktprellen in einfacher Weise diskriminiert werden.

In einem anderen Anwendungsfall der Erfindung, bei dem speziell charakteristische Fehler von mit Wechselspannung betätigten Schaltgeräten erkannt werden soll, ist die Aufgabe dadurch gelöst, daß die Schallanalyse zur Fehlererkennung speziell in dem Zeitintervall durchgeführt wird, in dem bei Gutteilen der magnetische Anker in Ruhe ist, und daß die auftretenden Schallsignale zur Klassifikation der Fehler verwendet werden. Damit können beispielsweise das sogenannte Brummen oder das sogenannte Schnarren von mit Wechselstrom betriebenen Schaltgeräten erkannt werden.

Schließlich wird in einem weiteren Anwendungsfall die Erfindung zur sogenannten Wohlklang-Beurteilung von Kraftfahrzeugrelais, welche bisher rein subjektiv durch Abhören durchgeführt wird, eingesetzt. In diesem Zusammenhang ist die Aufgabe dadurch gelöst, daß die Schallsignale, die von dem Aufschlag der Kontakte und/oder des Ankers erzeugt werden, von dem Schall, der nach dem eigentlichen Schaltgeräusch auftritt und dessen Ursache ein Nachklingen von Bauteilen ist, getrennt und zur objektivierten Feststellung des sogenannten Wohlklangs eines Relais verwendet werden.

Im Rahmen der Erfindung kann einerseits mittels eines berührungslos angebrachten Sensors der Luftschall und/ oder die hochfrequente Schallemission erfaßt werden. Andererseits kann mittels eines das Schaltgerät berührenden Sensors der Körperschall und/oder die hochfrequente Schallemission erfaßt werden. Die Auswertung der Schallsignale können dabei in der Auswerteeinrichtung analog oder aber digital erfolgen.

Bei allen angegebenen Realisierungen der Erfindung werden vorteilhafterweise Frequenzen im Ultraschallbereich, d.h. zwischen etwa 50 kHz und 500 kHz, ausgewertet. Letzteres erlaubt eine genauere zeitliche Auflösung und eine bessere Trennung der unterschiedlichen Schallquellen als die Frequenzen unterhalb von 20 kH, also im Hörschallbereich.

Weitere Einzelheiten und Vorteile der Erfindung ergeben sich aus der nachfolgenden Figurenbeschreibung von Ausführungsbeispielen anhand der Zeichnung.

Es zeigen

FIG 1    Schallemissionssignale beim Schließen eines magnetisch betätigten Schaltgerätes,

FIG 2    den bei FIG 1 auftretenden Ankerweg,

FIG 3    eine FIG 1 entsprechende Darstellung mit Signalauswertung für Kontaktprellen und Ankeraufschlag,

FIG 4    ein sogenanntes Sonagramm für wechselstrombetätigte Schütze guter und schlechter Qualität,

FIG 5     die aus dem ersten Teil von FIG 4 abgeleitete Cepstrum-Funktion für ein Schütz guter Qualität,

FIG 6     die aus dem zweiten Teil von FIG 4 abgeleitete Cepstrum-Funktion für ein Schütz schlechter Qualität,

FIG 7     speziell für das Schalten von Blinkrelais ein Schallsignal als Funktion der Zeit,

FIG 8     ein Sonagramm für die in FIG 7 geschalteten Blinkrelais und

FIG 9     die aus FIG 8 abgeleiteten Schallpegel.

Im Rahmen einer integrierten Produktion von Schützen und/ oder Relais sind Prüfstationen zur Überprüfung einzelner Komponenten und Funktionseigenschaften notwendig. Innerhalb einer Prüfstation wird der von dem durch das Schaltgerät realisierten Prüfling abgegebene Luftschall, der sich bei Betätigung der Kontakte und/oder des Magnetankers ergibt, mit einem Mikrophon erfaßt.

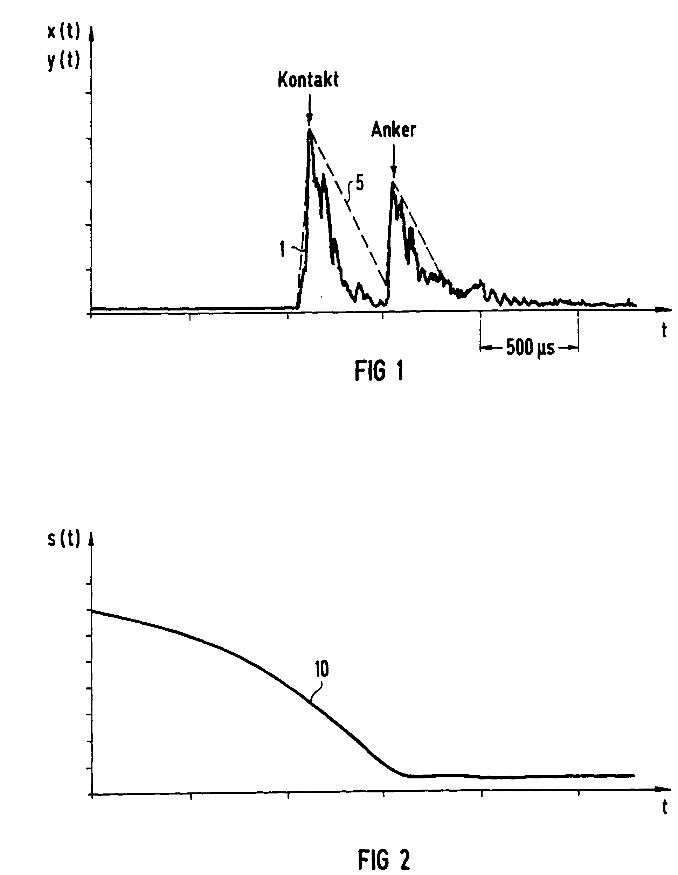

Statt des Mikrophons können auch andere Sensoren wie Beschleunigungs- und/oder Schallemissionsaufnehmer verwendet werden. Solche Sensoren liefern eine hochfrequente Wechselspannung, aus der sich insbesondere eine Hüllkurve als modifiziertes Schallsignal ableiten läßt. Eine gemessene Hüllkurve ist in FIG 1 mit 1 bezeichnet. Aus der Hüllkurve 1 soll der Zeitpunkt detektiert werden, an dem der Magnetanker des Schaltgerätes aufschlägt. Der Zeitpunkt des Aufschlagens der Kontakte läßt sich dagegen beispielsweise elektrisch ermitteln, insbesondere beim Kontaktschließen bei Schalten des Hauptstromkreises.

Speziell für eine digitale Signalauswertung wird folgendermaßen vorgegangen: Mit dem Anlegen der Spulenspannung wird die Datenerfassung getriggert und anschließend der Zeitpunkt des Kontaktschließens wie erwähnt erfaßt. Aus den bereits modifizierten und digitalisierten Schallsignalen wird eine Zeitreihe berechnet, wobei folgende Vorschrift zugrunde gelegt wird:

$$y(t) = \text{Max}(\text{abs}(x(t)), (y(t-1)-d))$$

mit

x(t:)        Abtastwert zur Zeit t
x(t-1):       vorangegangener Abtastwert
y(t):        Abtastwert der modifizierten Zeitreihe
d:           Abklingkonstante.

Gemäß obiger Definition gibt x(t) also die Hüllkurve 1 der Schallemissionssignale in FIG 1 wieder, während y(t) das modifizierte Signal entsprechend dem dort eingezeichneten Graphen 15 darstellt. Die Abklinpkonstante d ergibt sich schaltgerätespezifisch. Durch eine Berechnung des Zeitpunktes des höchsten Anstiege von y(t) läßt sich also in einfacher Form der Zeitpunkt des Aufschlagens des Magnetankers bestimmen. Im Rechner muß nun lediglich noch geprüft werden, ob dieser Zeitpunkt in einem zulässigen Zeitintervall liegt. Daraus wird eine Aussage über die Qualität des Schaltgerätes abgeleitet.

In FIG 2 ist mit 10 der Ankerweg s(t) bezeichnet. Der Vergleich der FIG 1 und 2 ergibt eindeutig, daß der gemäß obiger Vorschrift detektierte Zeitpunkt den Aufschlag des Ankers auf dem Magnetkern realisiert.

Alternativ zu vorstehend beschriebener Signalauswertung lassen sich bei im Prinzip gleicher Vorgehensweise die einzelnen Schritte auch mit einer analogen Signalauswertung realisieren. Dabei wird ebenfalls nach Triggerung der Datenerfassung und Bestimmung des Zeitpunktes des Kontaktschließens eine Hüllkurve aus dem Schallsignal erzeugt. In diesem Fall läßt sich beispielsweise aus der zeitlichen Ableitung der Hüllkurve, bei welcher der Wendepunkt der aufsteigenden Hüllkurve des Schallsignals ein Maximum realisiert, der Zeitpunkt des Ankeraufschlagens detektieren. Dieser Zeitpunkt wird wiederum hinsichtlich eines zulässigen Zeitfensters des untersuchten Schaltgerätes geprüft.

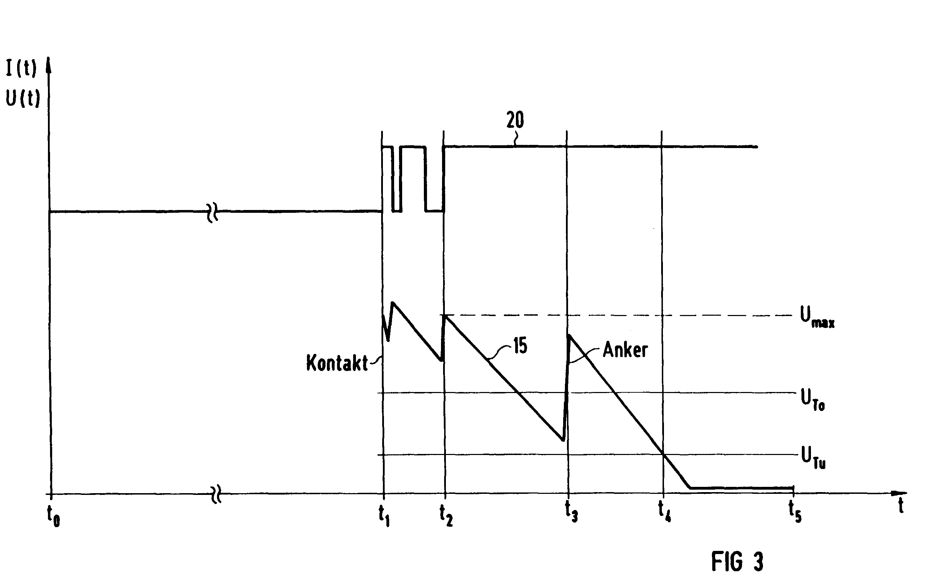

In Figur 3 ist mit 15 eine modifizierte Hüllkurve für den beim Schalten auftretenden Schall und mit 20 der dabei auftretende Kontaktstrom bezeichnet. Auf der Ordinate sind signifikante Zeitpunkte eingetragen: $t_0$ kennzeichnet den Meßbeginn, der durch Anlegen der Spulenspannung gekennzeichnet ist, $t_1$ bis $t_2$ das Kontaktschließen, $t_3$ bis $t_4$ den Ankeraufschlag und $t_5$ das Meßende. $U_{max}$ kennzeichnet den Maximalwert nach $t_2$ und $U_T$ Triggerschwellen.

Im Beispiel gemäß Figur 3 tritt beim Kontaktschließen ein Kontaktprellen auf. Letzteres kann durch geeignete Auswertung vom Ankeraufschlag diskriminiert werden: Dazu erfolgt durch die Spulenspannung getriggert die Signalerfassung von $t_0$ bis $t_5$. Die Zeiten $t_1$ und $t_2$ können aus dem Graphen 20 ermittelt werden. Anschließend wird $U_{max}$ festgestellt und werden Triggerschwellen $U_{To}$ und $U_{Tu}$ in Abhängigkeit von $U_{max}$ ermittelt. Aus dem modifizierten Signal 15 läßt sich dann $t_3$ und $t_4$ ermitteln und mittels Grenzwertvergleich die Zeitpunkte $t_1$ für das Kontaktschließen, $t_2 - t_1$ für das Prellen, $t_4 - t_3$ als Bedingung für den Ankeraufschlag sowie $t_3 - t_1$ als Zeitpunkt für den Ankeraufschlag bestimmen. Die Berechnung kann ebenfalls mit digitalen Methoden anhand des erstgenannten Beispieles erfolgen.

Langzeiterprobungen haben gezeigt, daß die Signalauswertungen gemäß FIG 1 und FIG 3 konsistente Ergebnisse liefern. Das beschriebene Verfahren läßt sich zu einer sogenannten 100 %-Prüfung im Rahmen einer integrierten Produktion einsetzen.

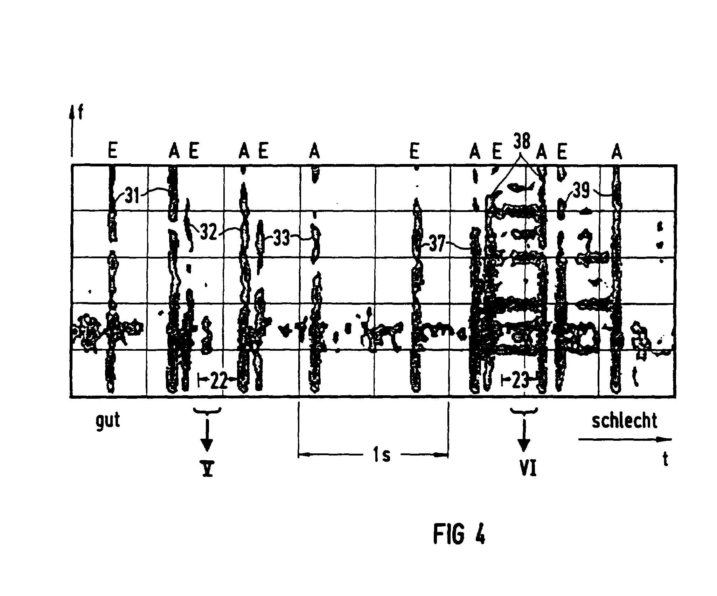

Speziell zur Klassifikation von Fehlern in elektromagnetisch betätigten Schaltgeräten wird das Verfahren gemäß den Figuren 4 bis 6 ausgeführt. Hierzu werden die beim Schalten über einen Schallsensor erfaßten Signale zwecks Auswertung in einem Rechner (PC) mittels eines A/D-Wandlers digitalisiert und temporär gespeichert. Im Rechner wird derjenige Signalaus schnitt ausgewertet, in dem bei "guten Prüflingen" der Anker schon zur Ruhe gekommen ist und demzufolge kein Schall abgestrahlt wird.

Die Sonagramm-Darstellung gemäß FIG 4 beinhaltet jeweils für einzelne Schalterbetätigungen die FFT-Spektren (fast fourier transformation) als Funktion der Zeit. Es sind drei Schaltvorgänge 31 bis 33 für ein Schütz guter Qualität und drei Schaltvorgänge 37 bis 39 für ein Schütz schlechter Qualität dargestellt, wobei jeweils der Einschaltvorgang mit E und der Ausschaltvorgang mit A bezeichnet ist.

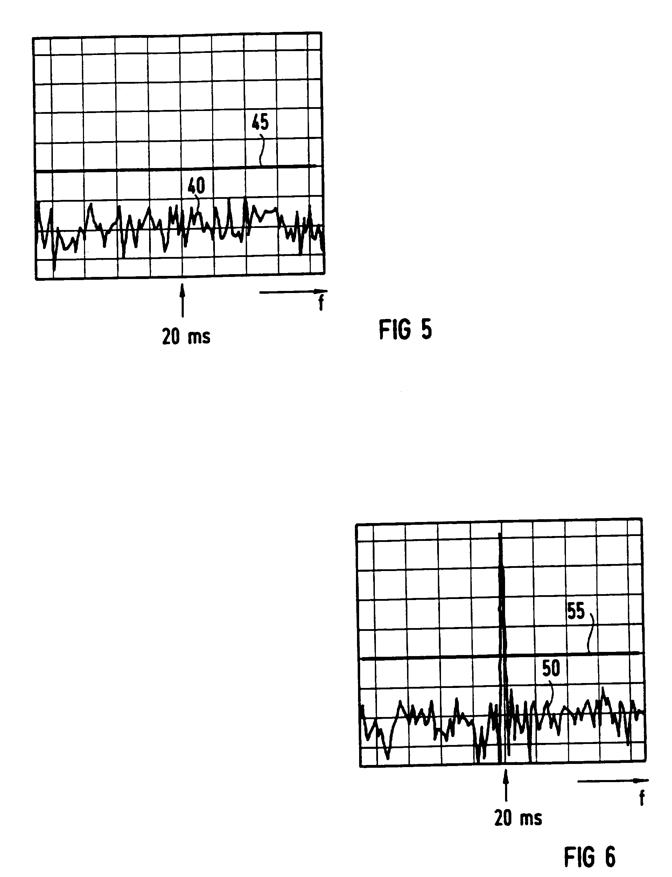

Bei der Sonagramm-Darstellung wird im allgemeinen die Intensität des bei den unterschiedlichen Fourier-Frequenzen auftretenden Schalls durch unterschiedliche Farben wiedergegeben, die als Amplituden senkrecht zur Papierebene vorstellbar sind. Letzteres ist aber bei der Auswertung des Beispiels gemäß FIG 4 bis 6 nicht von Bedeutung. Wichtig ist vielmehr, daß bei einem Schaltintervall von etwa einer halben Sekunde bei Gutteilen nach etwa 200 ms kein Schall mehr auftritt. Speziell die Zeitintervalle 22 und 23 der FIG 4 werden nunmehr ausgewertet, wobei die Auswertebereiche gemäß FIG 5 und 6 jeweils eine Periodendauer von 20 ms haben.

Wenn in einem Zeitintervall, in dem bei Gutteilen kein Signalspektrum vorhanden ist, dennoch Signale auftreten, können diese entweder dem sogenannten Brummen, bei dem ein periodisches Spektrum vorliegt, oder dem sogenannten Schnarren, bei dem ein nichtperiodisches Spektrum vorliegt, zugeordnet werden. Beides sind typische Fehler bei elektromagnetisch betätigten Schaltgeräten. Mit einer digitalen Signalauswertung kann dieser Fehler in einfacher Weise erkannt werden.

Zur Erkennung des Brummens wird aus der Zeitreihe des digitalisierten Schallsignals die Cepstrum-Funktion gebildet. Das Cepstrum ergibt sich aus der inversen Fouriertransformierten des logarithmierten Leistungsspektrums. Der Zahlenwert, der bei der Periodendauer der Netzfrequenz liegt, ist ein Maß für die Stärke des Brummens. Die Cepstrum-Funktion ist in den Figuren 5 und 6 mit 40 und 50 angegeben. Bei Gutteilen entsprechend FIG 5 liegt die Cepstrum-Funktion 40 in der Streubreite der jeweils benachbarten Werte. Bei brummenden Schützen liegt dagegen die Cepstrum-Funktion 50 gemäß FIG 6 deutlich über der Streubreite der benachbarten Werte. Der Vergleich der Maximalwerte der Kurven 40 bzw. 50 mit einem vorgegebenen Grenzwert, beispielsweise den Schwellen 45 bzw. 55 in FIG 5 und FIG 6, liefert die Aussage, ob ein fehlerhaftes Schütz mit brummender Charakteristik vorliegt.

Das sogenannte Schnarren kann mit letzterer Auswertung nicht diskriminiert werden. Das Schnarren wird durch das mehrfache Aufschlagen des Ankers auf den Magnetkern verursacht und es äußert sich in einer starken Erhöhung der Signalamplitude, beispielsweise um das 10fache. Dieser Fehler kann daher bereits allein durch die Berechnung des Effektivwertes der Signalamplitude mit anschließendem Grenzwertvergleich festgestellt werden.

Während also bei der Funktionsprüfung von mit Wechselspannung betätigten Schützen oder Relais das Schnarren des Magnetankers sich als Fehler durch die hohe Schallintensität äußert, kann letztere beim Brummen des Magnetankers gering sein. Dadurch ist dieser Fehler mit herkömmlichen Methoden nicht ohne weiteres erkennbar. Hier eröffnet die Cepstrumanalyse, die bisher zur Sprachanalyse eingesetzt wurde, eine verbesserte Fehlerdiskriminierung.

Das anhand der FIG 4 bis 6 beschriebene Auswerteverfahren kommt mit einem üblicherweise in der Prüfstation bereits vorhandenen PC aus. Es kann daher ohne weiteren Aufwana innerhalb einer normalen Montagelinie eingesetzt werden und ist unempfindlich gegen Störschall. Die Prüfung kann im Takt der Fertigungslinie erfolgen, wobei gleichzeitig weitere elektrische oder mechanische Prüfungen durchgeführt werden können. Langzeiterprobungen haben gezeigt, daß die Signalauswertungen gemäß FIG 4 bis 6 konsistente Ergebnisse liefern.

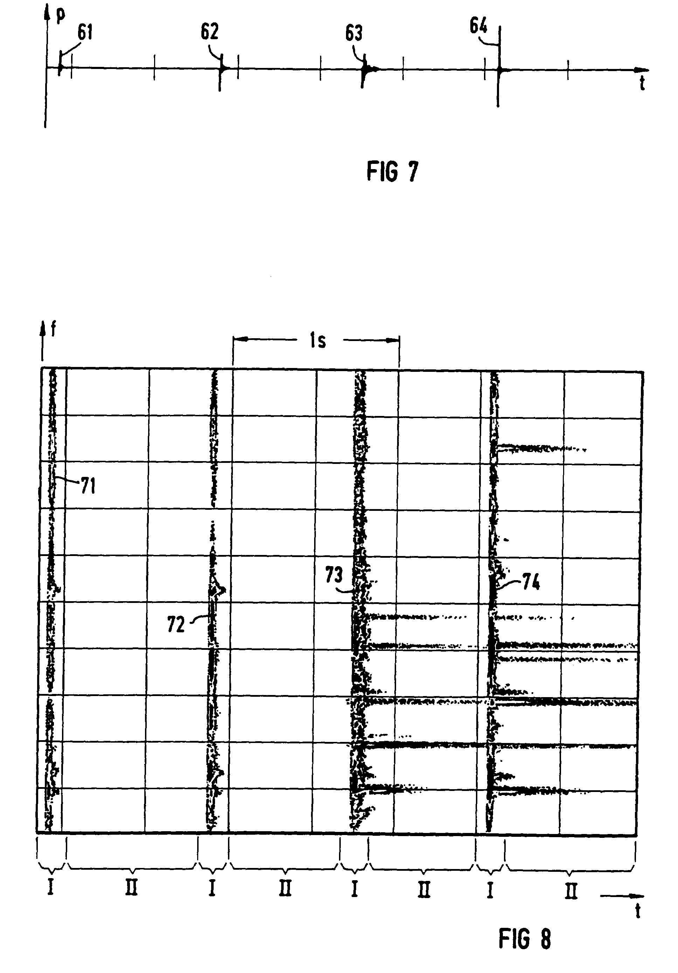

Die Figuren 7 bis 9 zeigen ein Verfahren zur objektivierten Erfassung des sogenannten Wohlklangs speziell bei Kfz-Blinkrelais. Solche Blinkrelais sollen "angenehm" klingen, d.h. einen "trockenen" bzw. "satten" Klang als sogenannten Wohlklang erzeugen und insbesondere beim Schalten nicht nachklingen. Speziell letzteres Problem einer sogenannten Wohlklang-Beurteilung wurde bisher rein subjektiv durch Abhören gelöst. Standardisierte akustische Meßverfahren, die von einer Mittelwertbildung ausgehen und beispielsweise eine Frequenzanalyse ausführen, sind dafür nicht geeignet.

Im Rahmen einer digitalen Auswertung mittels eines Rechners kann insbesondere das digitalisierte Schallsignal im Rechner gespeichert werden. Dabei werden vorzugsweise aus den gespeicherten Werten ein erster Zeitabschnitt, in dem das Aufschlaggeräusch liegt, und ein zweiter Zeitabschnitt, in dem das Aufschlaggeräusch bereits abgeklungen ist, definiert und werden beide Zeitabschnitte separat ausgewertet. Nunmehr können für jeden der beiden Zeitabschnitte spezifische Merkmale, beispielsweise bandbegrenzte Pegel, berechnet und hinsichtlich vorgegebener Kriterien klassifiziert werden. Insbesondere für letzteres ist es auch möglich, selbstlernende Klassifikatoren, beispielsweise neuronale Netze, einzusetzen.

Das Prinzip der vorgeschlagenen Methode besteht darin, bei einem Relais diejenigen zeitlichen Anteile des Schaltgeräusches, die vom Aufschlagen des Kontaktes einerseits und des Ankers andererseits erzeugt werden, von denjenigen Anteile zu trennen, deren Ursachen das Nachklingen anderer Bauteile des Relais sind. Letzteres Nachklingen kann beispielsweise durch eine Rückholfeder verursacht sein.

FIG 7 zeigt beispielhaft das Ein- und Ausschaltgeräusch von je einem "guten" und einem "schlechten" Relais. Dabei ist der Einschaltvorgang jeweils mit E und der Ausschaltvorgang mit A bezeichnet. Die Schallsignale sind jeweils im einzelnen mit 61 bis 64 bezeichnet. Obwohl die Schallsignale in Abhängigkeit von der Zeit eine durchaus unterschiedliche Struktur haben können, ist es nicht möglich, allein daraus eine Aussage über die Art des Klanges des Relais, insbesondere bei einem Blinkrelais, zu machen.

In FIG 8 beinhaltet die sogenannte Sonagramm-Darstellung für die einzelnen Relais-Betätigungen gemäß FIG 7 jeweils FFT-Spektren (fast fourier transformation) bei unterschiedlichen Zeiten. Die beiden ersten Sonagramm-Darstellungen 71 und 72 entsprechen den Schallsignalen 61 und 62 von FIG 7 und die beiden Sonagramm-Darstellungen 73 und 74 den Schallsignalen 63 und 64 von FIG 7.

Wie bereits erwähnt, wird bei der Sonagramm-Darstellung im allgemeinen die Intensität des bei den unterschiedlichen Fourier-Frequenzen auftretenden Schalls durch unterschiedliche Farben wiedergegeben, die auch als Amplituden senkrecht zur Papierebene vorstellbar sind. Letzteres ist aber bei Auswertung des Beispiels gemäß FIG 7 bis 9 ebenfalls nicht von Bedeutung. Wichtig ist vielmehr im vorliegenden Fall, daß bei wohlklingenden Relais Schallintensität in einem eng begrenzten Intervall I als erstem Zeitabschnitt auftritt. Dagegen treten bei schlecht klingenden Relais auch Schallintensitäten in einem Intervall II nach dem ersten Zeitabschnitt auf. In diesem als zweiten Zeitabschnitt definierten Intervall treten Schallintensitäten häufig bei diskreten Frequenzen des Spektrums auf und repräsentieren speziell den Nachhall beim Ausklinggeräusch.

Abstrakt betrachtet äußern sich die Schaltvorgänge in der gewählten quasi-dreidimensionalen Darstellung des Sonagramms gemäß FIG 8 als vertikale, die Nachhalltöne dagegen als horizontale Balken. Letztere sind dadurch in einfacher Weise diskriminierbar.

Zur technischen Ausführung kann eine Auswertung der Darstellung gemäß FIG 8 in einem Rechner dadurch realisiert werden, daß nach Erfassung der Schallsignale mit einem geeigneten Sensor, wie einem Mikrophon oder Beschleunigungsaufnehmer, eine Digitalisierung durch einen A/D-Wandler und eine temporäre Speicherung der digitalen Daten erfolgt. Bei den gespeicherten Daten kann nunmehr der erste Zeitabschnitt, in dem das Aufschlaggeräusch liegt, und der zweite Zeitabschnitt, in dem das Aufschlaggeräusch bereits abgeklungen ist, definiert werden. Für jeden der beiden Zeitabschnitte werden Merkmale wie beispielsweise bandbegrenzte Pegel berechnet. Durch Klassifikation der Merkmale anhand von Erfahrungswerten kann dann die Auswertung und die Aussage über einen objektivierten Wohlklang des Relais erfolgen.

Zur Klassifikation der Merkmale ist ein selbstlernender Klassifikator unter Verwendung von beispielsweise neuronalen Netzen einsetzbar. Der Klassifikator kann sich in einer Trainingsphase, in der neben den erfaßten Merkmalen auch eine subjektive Klassifikation des Prüfers eingegeben wird, selbst einstellen. In der anschließenden Prüfphase wird somit die Beurteilung des Prüfers reproduzierbar nachvollzogen.

Alternativ zur Verwendung eines selbstlernenden Klassifikators kann auch ein Merkmalssatz anhand einer Formel auf einer Notensskala abgebildet werden und Grundlage für die Beurteilung der Relais bilden.

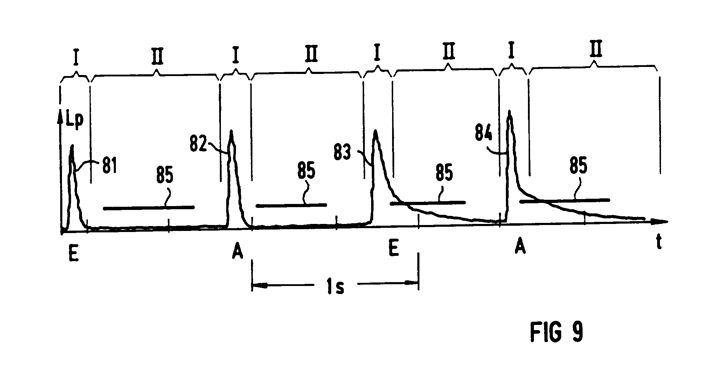

In der FIG 9 ist gemäß einer vereinfachten Auswertemethode der Schallpegel in den einzelnen Zeitabschnitten dargestellt. Dabei ergibt sich in eindeutiger Weise jeweils im ersten Zeitabschnitt ein größenordnungsmäßig in etwa gleicher Schallpegel 81 bis 84. Im zweiten Zeitabschnitt gehen bei guten Relais die Schallpegel 81 und 82 mit ihrem Wert gegen Null und klingen bei schlechten Relais die Schallpegel 83 und 84 langsamer ab. Die Werte der Abklingflanken können mittels geeigneter Schwellwerterfassungsmittel gemessen werden. Wenn beispielsweise eine Schwelle 85 vorgegeben wird, kann daraus eine Aussage über ein gutes bzw. schlechtes Relais abgeleitet werden.

In allen Fällen läßt die Realisierung eines objektiven Prüfsystems eine bessere Aussage über den Klang von Relais, insbesondere den sogenannten Wohlklang, zu. Mit der Auswertung gemäß FIG 7 bis 9 wird die Bemusterung von neuen Varianten der Relais vereinfacht und es wird somit die Qualitätsprüfung der Relais ergänzt. Das Verfahren kann vorteilhaft zur Beurteilung von Kraftfahrzeug-Blinkrelais eingesetzt werden. Es ist damit ein objektives Meßverfahren geschaffen, das die Abnahmeverhandlungen bei der Lieferung der Relais durch Kfz-Zulieferer erleichtert.

## Patentansprüche

1. Prüfverfahren zur Qualitätskontrolle von elektromagnetisch betätigten Schaltgeräten, bei denen durch Betätigen eines Magnetankers Stromkontakte geschlossen werden, wobei die Prüfung eine Analyse der unter Betriebsbedingungen auftretenden Vibrationen bzw. der Schallemission umfaßt, wozu der bei Betätigung des Schaltgerätes abgegebene Schall mittels eines Sensors erfaßt und einer Auswerteeinrichtung zur Diskriminierung des zeitlichen und/oder frequenzmäßigen Verlaufes einzelner Schallanteile zugeführt wird, **dadurch gekennzeichnet,** daß die durch das Aufschlagen der Kontakte einerseits und des Ankers andererseits verursachten Schallsignale erfaßt und voneinander getrennt werden und daß allein das vom Ankeraufschlag bewirkte Schallsignal ausgewertet wird.

2. Verfahren nach Anspruch 1, **dadurch gekennzeichnet,** daß der Zeitpunkt des Aufschlagens der Kontakte durch das Schließen des Hauptstromkreises erfaßt wird.

3. Verfahren nach Anspruch 1, **dadurch gekennzeichnet,** daß zur digitalen Auswertung nach Triggerung der Datenerfassung und nach Erfassung des Zeitpunktes des Kontaktschließens die Berechnung einer modifizierten Zeitreihe aus dem Schallsignal gemäß

$$y(t) = Max(abs(x(t)), (y(t-1)-d))$$

mit

| | |
|---|---|
| x(t): | Abtastwert zur Zeit t |
| abs(x(t)): | Absolutwert von x(t) |
| x(t-1): | vorangegangener Abtastwert |
| y(t): | Abtastwert der modifizierten Zeitreihe |
| d: | Abklingkonstante |

durchgeführt wird, daß daraus der Zeitpunkt des höchsten Anstieges von y(t) als Zeitpunkt des Aufschlagens des Magnetankers detektiert wird und daß dieser Zeitpunkt hinsichtlich eines zulässigen Zeitfensters für das untersuchte Schaltgerät geprüft wird.

4. Verfahren nach Anspruch 1,
**dadurch gekennzeichnet,** daß zur analogen Signalauswertung nach Triggerung der Datenerfassung und Erfassung des Zeitpunkts des Kontaktschließens eine Hüllkurve aus dem Schallsignal erzeugt wird, aus dessen zeitlicher Ableitung der Zeitpunkt des Ankeraufschlagens detektiert wird und daß dieser Zeitpunkt hinsichtlich eines zulässigen Zeitfensters des untersuchten Schaltgerätes geprüft wird.

5. Prüfverfahren zur Qualitätskontrolle von elektromagnetisch betätigten Schaltgeräten, bei denen durch Betätigen eines Magnetankers Stromkontakte geschlossen werden, wobei die Prüfung eine Analyse der unter Betriebsbedingungen auftretenden Vibrationen bzw. der Schallemission umfaßt, wozu der bei Betätigung des Schaltgerätes abgegebene Schall mittels eines Sensors erfaßt und einer Auswerteeinrichtung zur Diskriminierung des zeitlichen und/oder frequenzmäßigen Verlaufes einzelner Schallanteile zugeführt wird, **dadurch gekennzeichnet**,
daß eine Schallanalyse in dem Zeitbereich durchgeführt wird, in dem bei Gutteilen der magnetische Anker in Ruhe ist, und daß die auftretenden Schallsignale zur Klassifikation von Fehlern in elektromagnetisch betätigten Schaltgeräten, insbesondere bei mit Wechselspannung betriebenen Schützen oder Relais, verwendet werden.

6. Verfahren nach Anspruch 5, **dadurch gekennzeichnet,** daß zum Erkennen von sogenanntem Brummen im Schaltgerät aus den erfaßten Schallsignalen die sogenannte Cepstrum-Funktion berechnet wird.

7. Verfahren nach Anspruch 5, **dadurch gekennzeichnet,** daß zum Erkennen von sogenanntem Schnarren im Schaltgerät aus den Schallsignalen der Effektivwert der Signalamplitude berechnet wird.

8. Prüfverfahren zur Qualitätskontrolle von elektromagnetisch betätigten Schaltgeräten, bei denen durch Betätigen eines Magnetankers Stromkontakte geschlossen werden, wobei die Prüfung eine Analyse der unter Betriebsbedingungen auftretenden Vibrationen bzw. der Schallemission umfaßt, wozu der bei Betätigung des Schaltgerätes abgegebene Schall mittels eines Sensors erfaßt und einer Auswerteeinrichtung zur Diskriminierung des zeitlichen und/oder frequenzmäßigen Verlaufes einzelner Schallanteile zugeführt wird, **dadurch gekennzeichnet,**
daß die Schallsignale, die von dem Aufschlagen der Kontakte und/oder des Ankers erzeugt werden, von dem Schall, der nach dem eigentlichen Schaltgeräusch auftritt und dessen Ursache ein Nachklingen von Bauteilen ist, getrennt werden und daß die separierten Schallsignale zur objektivierten Feststellung eines sogenannten Wohlklanges eines Relais als Schaltgerät verwendet werden.

9. Verfahren nach Anspruch 8, **dadurch gekennzeichnet,** daß nach Erfassung und einer Digitalisierung des Schallsignales aus den gespeicherten Werten ein erster Zeitabschitt, in dem das Aufschlaggeräusch liegt, und ein zweiter Zeitabschnitt, in dem das Aufschlaggeräusch bereits abgeklungen ist, definiert werden und daß beide Zeitabschnitte separat ausgewertet werden.

10. Verfahren nach einem der Ansprüche 1, 4 oder 8, **dadurch gekennzeichnet**, daß mittels eines berührungslos angebrachten Sensors der Luftschall und/oder die hochfrequente Schallemission erfaßt wird.

11. Verfahren nach einem der Ansprüche 1, 4 oder 8, **dadurch gekennzeichnet,** daß mittels eines das Schaltgerät berührenden Sensors der Körperschall und/oder die hochfrequente Schallemission erfaßt wird.

12. Verfahren nach einem der Ansprüche 1, 4 oder 8, **dadurch gekennzeichnet,** daß die Datenerfassung durch das Anlegen der Spulenspannung beim magnetischen Anker getriggert wird.

13. Verfahren nach einem der vorhergehenden Ansprüche, **dadurch gekennzeichnet,** daß ein selbstlernender Klassifikator, beispielsweise ein neuronales Netz, verwendet wird.

## Claims

1. Testing process for the quality control of electromagnetically actuated switching devices, in which current contacts are made by actuating a magnetic armature, the testing including an analysis of the vibrations or sound emission occurring under operating conditions, for which purpose sound emitted by the switching device when it is actuated is detected by means of a sensor and transmitted to an evaluation device for the discrimination of the time and/or frequency curve of individual sound components, characterized in that the sound signals caused on the one hand by the making of the contacts and on the other hand by the striking of the armature are detected and discriminated from each other and in that only the sound signal produced by the armature strike is evaluated.

2. Process according to Claim 1, characterized in that the instant of making the contacts is detected by the closure of the main current loop.

3. Process according to Claim 1, characterized in that, for the digital evaluation after triggering the data acquisition and after detecting the instant of the contact closure, the calculation of a modified time series from the sound signal is carried out according to

$$y(t) = Max(abs(x(t)), (y(t-1)-d))$$

where

x(t) :        sample value at time t
abs(x(t)) :   absolute value of x(t)
x(t-1):       previous sample value
y(t):         sample value of the modified time series
d:            decay constant,

in that the instant of the highest rise of y(t) is detected as the instant of the strike of the magnetic armature and in that this instant is tested with respect to a permissible time window for the switching device being examined.

4. Process according to Claim 1, characterized in that, for analog signal evaluation after triggering the data acquisition and detecting the instant of the contact closure, an envelope curve is generated from the sound signal, from whose time derivative the instant of striking of the armature is detected and in that this instant is tested with respect to a permissible time window for the switching device being examined.

5. Testing process for the quality control of electromagnetically actuated switching devices, in which current contacts are made by actuating a magnetic armature, the testing including an analysis of the vibrations or sound emission occurring under operating conditions, for which purpose sound emitted by the switching device when it is actuated is detected by means of a sensor and transmitted to an evaluation device for the discrimination of the time and/or frequency curve of individual sound components, characterized in that a sound analysis is carried out in the time range in which, in good parts, the magnetic armature is at rest, and in that the sound signals occurring are used for the classification of faults in electromagnetically actuated switching devices, preferably in the case of contactors or relays operated with alternating current.

6. Process according to Claim 5, characterized in that, for the recognition of so-called humming in switching devices, the so-called cepstrum function is calculated from the sound signals detected.

7. Process according to Claim 5, characterized in that, for the recognition of so-called chattering in switching devices, the effective value of the signal amplitude is calculated from the sound signals.

8. Testing process for the quality control of electromagnetically actuated switching devices, in which current contacts are made by actuating a magnetic armature, the testing including an analysis of the vibrations or sound emission occurring under operating conditions, for which purpose sound emitted during actuation of the switching device is detected by means of a sensor and transmitted to an evaluation device for the discrimination of the time and/or frequency curve of individual sound components, characterized in that the sound signals which are generated by the making of the contacts and/or by the striking of the armature are separated from the sound which occurs after the actual switching noise and whose cause is a post-oscillation of components, and in that the separated sound signals are used for the objectivized determination of a so-called proper sound of a relay as a switching device.

9. Process according to Claim 8, characterized in that, after detecting and digitizing the sound signal, a first time section, in which the striking noise lies, and a second time section, in which the striking noise has already decayed, are defined from the stored values and in that both time sections are separately evaluated.

10. Process according to one of Claims 1, 4 or 8, characterized in that the airborne sound and/or the high-frequency sound emission is detected by means of a sensor fitted without contact.

11. Process according to one of Claims 1, 4 or 8, characterized in that the structure-borne sound and/or the high-frequency sound emission is detected by means of a sensor contacting the switching device.

12. Process according to one of Claims 1, 4 or 8, characterized in that the data acquisition is triggered by the application of the coil voltage in the magnetic armature.

13. Process according to one of the preceding claims, characterized in that a self-learning classifier, for example a neural network, is used.

## Revendications

1. Procédé de vérification pour le contrôle de la qualité d'appareils de commutation commandés électromagnétiquement, dans lesquels des contacts électriques sont fermés par la commande d'un induit magnétique, la vérification comprenant une analyse des vibrations, resp. des émissions sonores émises dans des conditions de service, ce pourquoi le son émis lors de la commande de l'appareil de commutation est détecté par un capteur et amené à un dispositif d'analyse pour la discrimination de l'allure temporelle et/ou fréquentielle des composants individuels du son, **caractérisé en ce que** les signaux sonores causés par l'impact des contacts d'une part et de l'induit d'autre part sont détectés et séparés les uns des autres et en ce que seul le signal produit par l'impact de l'induit est analysé.

2. Procédé selon la revendication 1, **caractérisé en ce que** le moment de l'impact des contacts est détecté par la fermeture du circuit électrique principal.

3. Procédé selon la revendication 1, **caractérisé en ce que** pour l'analyse numérique après le déclenchement de la saisie des données et la détection du moment de la fermeture du contact, le calcul d'une série de temps modifiée est effectué à partir du signal sonore selon la formule

$$y(t) = Max(abs(x(t)), (y(t-1)-d))$$

dont x(t:) valeur de lecture au temps t
abs(x(t)): valeur absolue de x(t)
x(t-1): valeur de lecture précédente
y(t): valeur de lecture de la série de temps modifiée
d: coefficient d'amortissement, en ce que le moment de la montée maximale de y(t) est détecté comme moment de l'impact de l'induit magnétique à partir de cette formule et en ce que ce moment est vérifié par rapport à une fenêtre de temps admise pour l'appareil de commutation examiné.

4. Procédé selon la revendication 1, **caractérisé en ce que** pour l'analyse analogique des signaux après déclenchement de la saisie des données et détection du moment de la fermeture du contact, une enveloppante est générée à partir du signal sonore, à partir de la déduction temporelle duquel le moment de l'impact de l'induit est détecté et en ce que ce moment est vérifié par rapport à une fenêtre de temps admise de l'appareil de commutation examiné.

5. Procédé de vérification pour le contrôle de la qualité d'appareils de commutation commandés électromagnétiquement, dans lesquels des contacts électriques sont fermés par la commande d'un induit magnétique, la vérification comprenant une analyse des vibrations, resp. des émissions sonores émises dans des conditions de service, ce pourquoi le son émis lors de la commande de l'appareil de commutation est détecté par un capteur et amené à un dispositif d'analyse pour la discrimination de l'allure temporelle et/ou fréquentielle des composants individuels du son, **caractérisé en ce que** une analyse du son est effectuée dans la plage de temps dans laquelle avec des pièces de bonne qualité l'induit magnétique est au repos et en ce que les signaux sonores émis sont utilisés pour la classification des défauts dans des appareils de commutation commandés électroniquement, notamment avec des contacteurs ou des relais fonctionnant avec du courant alternatif.

6. Procédé selon la revendication 5, **caractérisé en ce que** pour la détection de ce que l'on appelle un ronflement d'appareil de commutation la fonction dite Cepstrum est calculée à partir des signaux sonores détectés.

7. Procédé selon la revendication 5, **caractérisé en ce que** pour la détection de ce que l'on appelle le ronflement dans l'appareil de commutation, la valeur effective de l'amplitude des signaux est calculée à partir des signaux sonores.

8. Procédé de vérification pour le contrôle de la qualité d'appareils de commutation commandés électromagnétiquement, dans lesquels des contacts électriques sont fermés par la commande d'un induit magnétique, la vérification comprenant une analyse des vibrations, resp. des émissions sonores émises dans des conditions de service, ce pourquoi le son émis lors de la commande de l'appareil de commutation est détecté par un capteur et amené à un dispositif d'analyse pour la discrimination de l'allure temporelle et/ou fréquentielle des composants individuels du son, **caractérisé en ce que,** les signaux sonores produits par l'impact des contacts et/ou de l'induit sont séparés du son émis après le bruit de commutation proprement dit et dont la cause est une résonnance de composants et en ce que les signaux sonores séparés sont utilisés pour la constatation objectivée de ce que l'on appelle une harmonie du son d'un relais en tant qu'appareil de commutation.

9. Procédé selon la revendication 8, **caractérisé en ce que** après détection et une numérisation du signal sonore à partir des valeurs mémorisées, un premier intervalle de temps, dans lequel se trouve le bruit d'impact, et un second intervalle de temps, dans lequel le bruit d'impact s'est déjà dissipé, sont définis et en ce que les deux intervalles de temps sont analysés séparément.

10. Procédé selon l'une des revendications 1, 4 ou 8, **caractérisé en ce que** le bruit transmis par l'air et/ou l'émission sonore haute fréquence sont détectés au moyen d'un capteur monté sans contact.

11. Procédé selon l'une des revendications 1, 4 ou 8, **caractérisé en ce que** le bruit transmis par les solides et/ou l'émission sonore haute fréquence sont détectés au moyen d'un capteur au contact de l'appareil de commutation.

12. Procédé selon l'une des revendications 1, 4 ou 8, **caractérisé en ce que** la saisie des données est déclenchée par l'application de la tension de la bobine sur l'induit magnétique.

13. Procédé selon l'une des revendications précédentes, **caractérisé en ce que** un classificateur autodidacte, comme par exemple un réseau neuronal, est utilisé.

FIG 1

FIG 2

I(t)
U(t)

20

$U_{max}$

Kontakt

15

Anker

$U_{To}$

$U_{Tu}$

$t_0$  $t_1$  $t_2$  $t_3$  $t_4$  $t_5$  t

FIG 3

EP 0 641 446 B1

FIG 4

FIG 5

20 ms

FIG 6

20 ms

FIG 7

FIG 8

14

FIG 9